# EUROPÄISCHE PATENTSCHRIFT

(11) **EP 2 596 682 B1**
(45) Veröffentlichungstag und Bekanntmachung des Hinweises auf die Patenterteilung: **08.06.2016**
(21) Anmeldenummer: 11732355.0
(22) Anmeldetag: 06.04.2011
(51) Int. Cl.: H05B 37/02

(54) **STEUERVORRICHTUNG UND VERFAHREN ZUR DETEKTION EINER LASTART**
CONTROL APPARATUS AND METHOD FOR DETECTING A TYPE OF LOAD
DISPOSITIF DE COMMANDE ET PROCÉDÉ DE DÉTECTION D'UN TYPE DE CHARGE

(30) Priorität: 20.10.2010 DE 102010048980; 19.04.2010 DE 102010015625
(43) Veröffentlichungstag der Anmeldung: 29.05.2013
(73) Patentinhaber: permundo GmbH, 40215 Düsseldorf (DE)
(72) Erfinder: AUMANN, Gregor Maria Ernst Walter, 40479 Düsseldorf (DE)
(74) Vertreter: Isfort, Olaf
(86) Internationale Anmeldenummer: PCT/EP2011/001696
(87) Internationale Veröffentlichungsnummer: WO 2011/131291

(56) Entgegenhaltungen:
- WO-A2-2010/034509
- DE-U1-202007 015 857
- GB-A- 2 326 543

## Beschreibung

Die Erfindung betrifft eine Steuervorrichtung zur Steuerung einer Last, wobei die Steuervorrichtung zwischen eine Spannungsquelle und die Last schaltbar ist und eine Steuerschaltung und einen Lastartdetektor umfasst. Weiterhin betrifft die Erfindung ein Verfahren zur Detektion der Lastart einer Last.

Die meisten Gebäude sind mit elektronischen Vorrichtungen zur Steuerung elektrischer Verbraucher ausgestattet. Eine häufig anzutreffende Ausführungsform einer solchen elektronischen Vorrichtung ist der Lichtdimmer, der zur Steuerung der Helligkeit von Leuchten eingesetzt wird. Ein bekanntes Problem beim Einsatz von Lichtdimmern ist die Notwendigkeit, dass das Steuerprinzip des Lichtdimmers an die elektrischen Eigenschaften der zu steuernden Leuchte angepasst sein muss und deswegen die Auswahl und Montage eines für die zu steuernde Leuchte geeigneten Dimmers spezieller Fachkenntnisse bedarf.

Eine bekannte Lösung für dieses Problem sind sogenannte Universaldimmer, die nach unterschiedlichen Messprinzipien das Vorhandensein eines induktiven Anteils im komplexen Lastwiderstand der Leuchte ermitteln und bei Vorhandensein eines solchen induktiven Anteils als Steuerprinzip den Phasenanschnitt wählen und bei Nichtvorhandensein eines solchen induktiven Anteils als Steuerprinzip den Phasenabschnitt verwenden.

Aus der DE 43 10 723 A1, der EP 0 618 667 B1 und der EP 0 923 274 B1 sind Verfahren und Vorrichtungen bekannt, bei denen die Last nach dem Anlegen der Netzspannung zunächst mit einem Stromimpuls beaufschlagt wird und das Vorhandensein eines induktiven Anteils an der Höhe des beim Abschalten des Stromimpulses entstehenden Spannungsimpulses erkannt wird.

Aus der WO 92/15052, der US 6,813,720 B2, der EP 1 414 144 A1 und der WO 2009/36515 A1 sind weitere Verfahren und Vorrichtungen bekannt, bei denen der Dimmer zunächst im Sinne einer Phasenabschnittsteuerung auf die Last einwirkt und beim Auftreten von Spannungsimpulsen an den Anschlüssen der Last das Steuerprinzip wechselt und fortan im Sinne einer Phasenanschnittsteuerung auf die Last einwirkt.

In der DE 197 51 828 B4 wird vorgeschlagen, zur Erkennung eines induktiven Anteils in der Last zunächst die Last im Sinne einer Phasenanschnittsteuerung kurz vor dem Spannungsnulldurchgang der Netzspannung einzuschalten und im Nulldurchgang des Laststroms wieder auszuschalten und diese Prozedur jede übernächste Halbwelle der Netzspannung zu wiederholen und dabei zu überprüfen, ob sich der Nulldurchgang des Laststroms gegenüber dem Spannungsnulldurchgang der Netzspannung zeitlich verschoben hat, um aus einer eventuellen Verschiebung auf das Vorhandensein eines induktiven Anteils in der Last zu schließen.

Auch bei einem Verfahren nach der EP 1 313 205 B1 wird nach dem Anlegen der Netzspannung zunächst ein Testprogramm absolviert, bei dem die Last im Spannungsnulldurchgang der Netzspannung eingeschaltet wird und beim darauffolgenden Abschalten der Last im Stromnulldurchgang des Laststroms überprüft wird, ob dieser relativ zum Spannungsnulldurchgang der Netzspannung zeitlich verschoben ist und anhand einer eventuellen Verschiebung die Lastart bestimmt.

Die Erkennung eines eventuellen induktiven Lastanteils, wie aus dem Stand der Technik bekannt, ist lediglich ausreichend, um eine Steuervorrichtung zu konstruieren, die sich ausschließlich für Leuchten eignet, die entweder Hochvolt- oder Niedervolt-Glühlampen als Leuchtmittel verwenden. Eine derart konstruierte Steuervorrichtung kann jedoch weder Energiesparlampen mit elektronischem Vorschaltgerät noch LED-Lampen geeignet ansteuern. Dies wäre jedoch beispielsweise für einen Universaldimmer wünschenswert, da letztgenannte Leuchtmittel in der jüngeren Vergangenheit stark an Verbreitung gewonnen haben.

Diesbezüglich schlägt die WO 2008/144095 A1 einen Dimmer vor, der zumindest zwischen einer Hochvolt-Glühlampe und einer Energiesparlampe mit elektronischem Vorschaltgerät unterscheiden kann. Wünschenswert wäre jedoch ein Universaldimmer mit dem sich alle üblich konstruierten Leuchten steuern lassen.

Die DE 20 2007 015 857 U1 beschreibt eine Helligkeitsregelung für elektrische Lichtquellen mit unterschiedlichen Strom/Helligkeitskennlinien mittels Pulsweitenmodulation, wobei zur Erkennung der spezifischen Kennlinie einer Lichtquelle dieser Prüfimpulse zugeführt werden.

Die WO 2010/034509 A2 beschreibt ein Verfahren zum Bestimmen der elektrischen Eigenschaften von OLEDs. Hierzu wird der zu untersuchenden OLED ein Mess- und/oder Ladestrom aufgeprägt und der Spannungsabfall über der OLED oder über einer Referenzkapazität gemessen. Widerstand und Kapazität der OLED werden in separaten, zeitlich getrennten Schritten bestimmt.

Der Erfindung liegt die Aufgabe zugrunde, ein Verfahren und eine Vorrichtung zur Steuerung einer Last in einem Wechselstromkreis zu schaffen, die sich für eine Vielzahl von Typen von Leuchten eignen, die in Privatwohnungen eingesetzt werden. Hierzu zählen z.B. Hochvoltglühlampen, Niedervolt-glühlampen mit magnetischem oder elektronischem Vorschaltgerät oder sogenannte Energiesparlampen mit Leuchtstoffröhren oder LEDs.

Die der Erfindung zugrunde liegende Aufgabe wird durch eine Steuervorrichtung mit den Merkmalen von Patentanspruch 1 und durch ein Verfahren gemäß Patentanspruch 10 gelöst. Bevorzugte Ausführungsformen der Erfindung sind in den abhängigen Patentansprüchen angegeben.

Ausführungsformen der Erfindung haben den Vorteil, dass verschiedene Arten von Lasten detektiert und in entsprechender Weise angesteuert werden können. Die Erfindung ermöglicht die Ermittlung einer Größe, die von der Impedanz der Last in allgemeinster Form, d.h. mit ohmschem, induktivem und kapazitivem Anteil, abgeleitet ist. Durch geeignete Analyse dieser Größe können ferner Aussagen über ein etwaiges nichtlineares Verhalten der Last, d.h. zeitliche Veränderungen der Impedanz getroffen werden. Dabei kann der eigentliche Detektionsvorgang vorteilhaft nach außen hin unsichtbar bleiben, da er erstens in sehr kurzer Zeit durchführbar ist und zweitens der auftretende Teststrom in der Weise begrenzt werden kann, dass die Last nicht bestimmungsgemäß (d.h. außerhalb der herstellerseitigen Spezifikationen) betrieben wird. Vermeidung eines bestimmungsgemäßen Betriebs bedeutet im Sinne der Erfindung, dass die Last keine für den Benutzer erkennbare Reaktion zeigt. Handelt es sich bei der Last um eine Leuchte, bedeutet dies, dass keine Leuchterscheinung für den Benutzer erkennbar ist. Der bestimmungsgemäße Betrieb wird durch geeignete Begrenzung der Stromstärke des Teststroms sowie ggf. durch die Beaufschlagung der Last mit dem Testsignal über einen (begrenzten) vorbestimmten Zeitraum vermieden. Voraussetzung hierfür ist, dass erfindungsgemäß Mittel zur Beaufschlagung der Last mit dem Testsignal vorgesehen sind, die in der Lage sind, das Testsignal zu erzeugen, während der erste Schalter, der gleichsam den "Hauptschalter" zur Steuerung des regulären Betriebs der Last bildet, geöffnet ist. Die Steuerschaltung der erfindungsgemäßen Vorrichtung sorgt somit dafür, dass die ersten Detektionsschritte bei ausgeschalteter Last durchgeführt werden können. Hierbei kann das Testsignal hinsichtlich Amplitude und Dauer unabhängig von der Versorgungsspannung der Last erzeugt werden.

Nach Durchführung der ersten Detektionsschritte kann erfindungsgemäß das Testsignal (jedenfalls vorerst) unterbrochen oder der Teststrom reduziert werden. Diese Maßnahme dient wiederum dazu, einen dauernden Teststromfluss durch die Last, der zu einer von außen erkennbaren unerwünschten Reaktion der Last führen könnte, zu vermeiden. Damit die Durchführung der ersten Detektionsschritte für den Benutzer (weitgehend) unbemerkt bleibt, sollte die Dauer der Durchführung der ersten Detektionsschritte insgesamt höchstens 200 ms, vorzugsweise höchstens 100 ms betragen.

Nach einer Weiterbildung der erfindungsgemäßen Vorrichtung ist diese weiterhin eingerichtet, im Anschluss an die ersten Detektionsschritte die folgenden zweiten Detektionsschritte auszuführen:
- Aufhebung der Unterbrechung bzw. der Reduktion des Teststroms während eines vorgegebenen Zeitintervalls bei weiterhin geöffnetem ersten Schalter,
- Erfassung der wenigstens einen von dem Teststrom und/oder der Testspannung abgeleiteten Größe durch die Messeinrichtung während der Aufhebung der Unterbrechung bzw. der Reduktion des Teststroms,
- Detektion einer Trennung und/oder einer Wiederherstellung der Verbindung zwischen Steuervorrichtung und Last durch Analyse der erfassten Größe. Alternativ können die folgenden zweiten Detektionsschritte ausgeführt werden:
- Ansteuerung der Mittel zur Beaufschlagung der Last mit dem Testsignal durch die Steuerschaltung bei geöffnetem ersten Schalter,
- Erfassung der wenigstens einen von dem Teststrom und/oder der Testspannung abgeleiteten Größe durch die Messeinrichtung,
- Detektion einer Trennung und/oder einer Herstellung der Verbindung zwischen Steuervorrichtung und Last durch Analyse der erfassten Größe. Bei diesen Ausgestaltungen wird die Last mit dem Teststrom beaufschlagt, wobei das Testsignal während der zweiten Detektionsschritte vorzugsweise so erzeugt wird, dass der Teststrom gegenüber den ersten Detektionsschritten eine reduzierte Stromstärke aufweist oder nur intermittierend (z.B. alle 100 ms) fließt. Es soll auf diese Weise sichergestellt sein, dass keine von außen für den Benutzer der Last erkennbare Reaktion der Last (z.B. kurze Leuchterscheinungen bei einer Lampe) erfolgt oder der Last kein Schaden zugefügt wird, auch wenn die zweiten Detektionsschritte kontinuierlich, d.h. ggf. über mehrere Minuten oder sogar Stunden, wiederholt werden. Durch Analyse der während der zweiten Detektionsschritte erfassten Messgröße kann (bei ausgeschalteter Last) eine Trennung der Last von der erfindungsgemäßen Steuervorrichtung detektiert werden. Eine solche Trennung findet beispielsweise statt, wenn ein der Last direkt zugeordneter oder in diese eingebauter Ein-/Ausschalter vom Benutzer betätigt wird. Die Detektion eines entsprechenden Ereignisses kann genutzt werden, um automatisch entsprechende Aktionen auszulösen. Z.B. kann die Detektion der Herstellung der Verbindung dazu genutzt werden, den ersten Schalter der erfindungsgemäßen Vorrichtung zu schließen, um die Last in Betrieb zu setzen. Auf diese Weise kann der Benutzer den Ein-/Ausschalter der Last wie gewohnt zum Ein- oder Ausschalten der Last benutzen. Weiterhin kann die Detektion des Ereignisses an weitere Geräte übermittelt werden, um dort entsprechende Aktionen ferngesteuert auszulösen. Z.B. kann die Detektion eines manuellen Ein- oder Ausschaltens der Last genutzt werden, um automatisch (auch) eine andere Last (oder mehrere andere Lasten) entsprechend ein- oder auszuschalten. Die zweiten Detektionsschritte dienen anders ausgedrückt dazu, festzustellen, ob überhaupt eine Last "vorhanden" ist.

Nach Detektion einer Trennung der Verbindung zur Last kann es sinnvoll sein, die Detektion der Last mittels der ersten Detektionsschritte von Neuem zu beginnen, um dem Fall Rechnung zu tragen, dass die ursprünglich mit der erfindungsgemäßen Steuervorrichtung verbundene Last durch eine andere Last ausgetauscht wird.

Es sei darauf hingewiesen, dass es für die Erfindung unerheblich ist, ob zuerst die ersten oder die zweiten Detektionsschritte ausgeführt werden. Es ist insbesondere denkbar, zunächst die zweiten Detektionsschritte wiederholt durchzuführen, und zwar bis die Herstellung einer Verbindung zwischen Steuervorrichtung und Last (z.B. durch manuelles Betätigen eines Ein-/Ausschalters) detektiert wird. Danach kann dann mittels der ersten Detektionsschritte die Lastart erkannt werden, bevor die Last durch entsprechendes Ansteuern des ersten Schalters der Steuervorrichtung aktiviert wird. Weiterhin kann nach Aktivieren der Last der fließende Betriebsstrom mittels der erfindungsgemäßen Steuervorrichtung überwacht werden, um z.B. auch ein manuelles Ausschalten der Last zu detektieren.

Nach einer Ausführungsform der Erfindung ist die Steuervorrichtung eingerichtet zur Erfassung einer von dem Teststrom abgeleiteten ersten Größe und einer von der Testspannung abgeleiteten zweiten Größe durch die Messeinrichtung.

Dies ermöglicht eine umfassende Analyse der Last zum Zwecke der Detektion der Lastart. Durch Auswertung des zeitlichen Verlaufs der Messgrößen kann die Lastart zuverlässig erkannt werden, wobei die Last passive und auch aktive Komponenten enthalten kann.

Nach einer weiteren Ausführungsform der Erfindung ist die Steuervorrichtung ferner dazu eingerichtet, nach Detektion der Lastart einen von der Spannungsquelle zur Last fließenden Strom zum Betrieb der Last mittels der Steuerschaltung durch entsprechende Ansteuerung des ersten Schalters gemäß einer der Lastart zugeordneten Steuermethode zu steuern. Damit ist ein optimaler Betrieb der speziellen Last und eine entsprechende Steuerung zum Erhalt eines gewünschten Betriebszustandes möglich. Eine übermäßige Belastung der Last kann so z.B. vermieden und die Lebensdauer der Last erhöht werden. Außerdem ermöglicht die Erfindung, verschiedenste Arten von Lasten mit derselben universellen Steuervorrichtung zu betreiben, und zwar jeweils gemäß der geeigneten individuellen "Kennlinie" der Last, z.B. zum Zwecke des Dimmens einer Leuchte. Mögliche Steuermethoden im Sinne der Erfindung sind z.B. Phasenanschnitt oder Phasenabschnitt.

Nach einer weiteren Ausführungsform der Erfindung umfasst die Steuervorrichtung eine mit der Steuerschaltung verbundene Kommunikationseinheit, wobei die Kommunikationseinheit zum Empfang von Fernsteuerdaten zur Fernsteuerung der Steuervorrichtung und/oder zum Senden von Zustands- und/oder Diagnosedaten der Steuervorrichtung ausgebildet ist. Damit kann flexibel "ferngesteuert" - entweder über ein intelligentes Netzwerk oder auch einfach unter Verwendung konventioneller (Ein-)Schaltmittel oder Fernbedienungen - ein Schaltvorgang zum Betrieb der Last geregelt werden. Ebenso kann eine Zustandsänderung in der Steuervorrichtung, z.B. das Entfernen der Last, anderen Geräten mitgeteilt werden.

Nach einer weiteren Ausführungsform der Erfindung weist die Steuervorrichtung einen Nullspannungsdetektor zur Detektion von Spannungsnulldurchgängen der mit der Steuervorrichtung verbundenen Spannungsquelle auf, wobei der Zeitpunkt des Beginns der erfindungsgemäß durchgeführten Messungen relativ zum Zeitpunkt eines detektierten Spannungsnulldurchgangs vorgegeben ist.

Dies vereinfacht aufgrund des Vorhandenseins eines "Referenzpunktes" die Lastartbestimmung und erhöht somit deren Zuverlässigkeit.

Nach einer weiteren Ausführungsform der Erfindung ist die Steuervorrichtung zum Zwecke der Analyse des zeitlichen Verlaufs der ersten und zweiten Größe dazu eingerichtet, im Verlauf des vorbestimmten Zeitraums von der ersten und/oder zweiten Größe mehrere Messungen zu unterschiedlichen vorbestimmten Zeitpunkten durchzuführen.

Zum Beispiel ist die Steuervorrichtung eingerichtet, die Lastart durch Vergleich der zu den unterschiedlichen vorbestimmten Zeitpunkten gewonnenen Messwerte mit die Lastart charakterisierenden gespeicherten Daten zu detektieren. Das bedeutet, dass der für eine bestimmte Lastart charakteristische Zeitverlauf der Messwerte durch Vergleich mit einer geeigneten Anzahl von durch vorgespeicherte Referenzwerte definierten Referenzkurven erkannt wird. Alternative Ansätze, die z.B. auf "Neurofuzzy"-Ansätzen basieren können, sind ohne Weiteres denkbar.

Nach einer weiteren Ausführungsform der Erfindung weist die Steuervorrichtung einen von der Steuerschaltung angesteuerten zweiten Schalter auf, der zur Beaufschlagung der Last mit dem Testsignal die Last über wenigstens eine Impedanz mit der Spannungsquelle trennbar verbindet. Die Impedanz bestimmt den Teststrom und ist hierzu geeignet gewählt. Der zweite Schalter wird von der Steuerschaltung so angesteuert, dass der Teststrom nur während eines vorbestimmten Zeitraums fließt. Alternativ kann eine parallel zu dem ersten Schalter geschaltete Impedanz und ein von der Steuerschaltung angesteuerter zweiter Schalter vorgesehen sein, der zur Begrenzung des durch die Last fließenden Teststroms eine weitere Impedanz parallel zur Last trennbar schaltet. Beide Varianten sind schaltungstechnisch mit geringem Aufwand realisierbar.

Nach einer weiteren Ausführungsform der Erfindung werden der erste Schalter und der zweite Schalter wechselweise geöffnet oder geschlossen. Bei dieser Ausgestaltung erfolgt die Detektion der Lastart ausschließlich während die Last außer Betrieb ist.

Nach einer weiteren Ausführungsform der Erfindung ist die Steuervorrichtung zur periodisch wiederholten Durchführung der ersten und/oder zweiten Detektionsschritte eingerichtet. Damit kann permanent überwacht werden, ob sich die Lastart ändert, bzw. ob überhaupt eine Last anliegt oder nicht. Die periodische Wiederholung kann außerdem durch statistische Mittelung dazu genutzt werden, die Genauigkeit und Zuverlässigkeit bei der Lastartdetektion zu erhöhen.

Gemäß der Erfindung ist die Steuervorrichtung ferner eingerichtet zur Durchführung der folgenden Detektionsschritte:
- Beaufschlagung der Last mit einem Betriebsstrom durch Schließen des ersten Schalters,
- Erfassung wenigstens einer von dem Betriebsstrom und/oder der an der Last abfallenden Betriebsspannung abgeleiteten Größe durch die wenigstens eine Messeinrichtung,
- Detektion der Lastart durch Analyse des zeitlichen Verlaufs der erfassten Größe.

Demnach wird die gemäß der Erfindung außerhalb des regulären Betriebs der Last erfolgende Detektion der Lastart ergänzt um eine Lastartdetektion während des regulären Betriebs, d.h. bei geschlossenem ersten Schalter. Damit sind auch Lasten erkennbar, deren Lastart nur durch Beaufschlagung mit dem Teststrom nicht oder nicht eindeutig identifizierbar ist. Die Detektion der Lastart erfolgt durch Analyse des zeitlichen Verlaufs der von Betriebsstrom und Betriebsspannung abgeleiteten Größen, indem von der erfassten Größe bzw. den erfassten Größen mehrere Messungen zu unterschiedlichen vorbestimmten Zeitpunkten durchgeführt werden, wobei dann die Lastart durch Vergleich der zu den unterschiedlichen vorbestimmten Zeitpunkten gewonnenen Messwerte mit die Lastart charakterisierenden gespeicherten Daten detektiert wird. Zweckmäßigerweise werden die während der ersten und der dritten Detektionsschritte erfassten Größen bei der Lastartdetektion kombiniert, um in allen relevanten Fällen die Last genau identifizieren zu können. Die Lastartdetektion während des regulären Betriebs kann vorteilhaft die Messung der Leistungsaufnahme der Last mit umfassen, um diese dann mit der nominellen Leistungsaufnahme zu vergleichen.

In einem weiteren Aspekt betrifft die Erfindung ein Computerprogrammprodukt mit von einem Prozessor ausführbaren Instruktionen zur Durchführung der oben beschriebenen Detektionsschritte.

Im Folgenden werden anhand der Zeichnungen Ausführungsbeispiele der Erfindung erläutert. Es zeigen:
- Figur 1: eine Blockschaltbild einer Steuervorrichtung gemäß der Erfindung,
- Figur 2: Schaltbilder von verschiedenen Ausführungsbeispielen der Erfindung,
- Figur 3: die Eingangsbeschaltung beispielhafter Lasttypen, sowie unterschiedliche Messsignalverläufe,
- Figur 4: einen beispielhaften Messsignalverlauf,
- Figur 5: Schaltbild eines weiteren Ausführungsbeispiels der Erfindung,
- Figur 6: weitere beispielhafte Messsignalverläufe sowie Schaltbild eines weiteren Ausführungsbeispiels,
- Figur 7: beispielhafte Teststromverläufe.

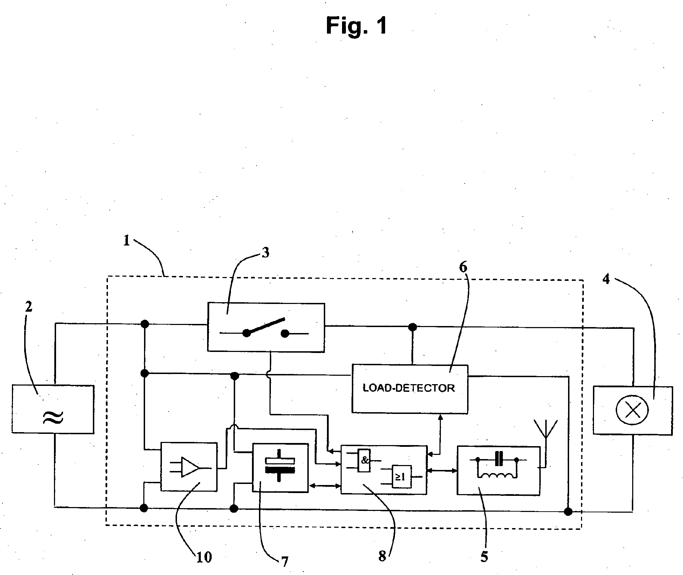

Die erfindungsgemäße Steuervorrichtung 1, wie sie in Fig. 1 dargestellt ist, umfasst die Funktionseinheiten erster Schalter 3, Stromversorgung 7, Steuerschaltung 8 und Lastartdetektor 6.

Dabei wird zur Steuerung einer Wechselstromlast 4 als erster Schalter 3 eine Anordnung aus einem oder mehreren abschaltbaren Halbleiterschaltern verwendet, die von einer Steuerschaltung 8 nach einer bestimmten Steuermethode angesteuert werden, z.B. im Sinne einer Phasenan- oder Phasenabschnittsteuerung oder nach einem anderen Verfahren bei dem der Halbleiterschalter 3 zu einem bestimmten Zeitpunkt während der Periode des Netzstroms eingeschaltet wird und zu einem anderen Zeitpunkt während der Periode wieder ausgeschaltet wird, z.B. nach dem in der DE 37 27 058 A1 vorgeschlagenen Verfahren.

Ebenso kann die Steuervorrichtung 1 eine Kommunikationseinheit 5 enthalten, zum Austausch von Fernsteuer- und Statusinformationen mit anderen Geräten oder zur Einbindung in ein Funknetzwerk, wie sie beispielsweise unter dem Namen ENOCEAN oder Z-WAVE am Markt verfügbar sind, oder zur Integration in ein drahtgebundenes Netzwerk, wie z.B. KNX oder LON.

Zusätzlich kann die Steuerschaltung 8, die häufig aus einem Mikrokontroller bestehen wird, alle Funktionseinheiten der Steuervorrichtung 1 kontrollieren. Möglich ist auch, dass die die Kommunikationseinheit 5 einen separaten Mikrocontroller zur Abwicklung des Kommunikationsprotokolls enthält.

Weiterhin enthält die dargestellte Steuervorrichtung 1 einen Nullspannungsdetektor 10 zum Erkennen des Spannungsnulldurchgangs der (Wechsel-) Spannungsquelle 2 und eine Vorrichtung zum Abschalten des ersten Schalters 3 im Nulldurchgang des durch den Schalter 3 fließenden Stroms.

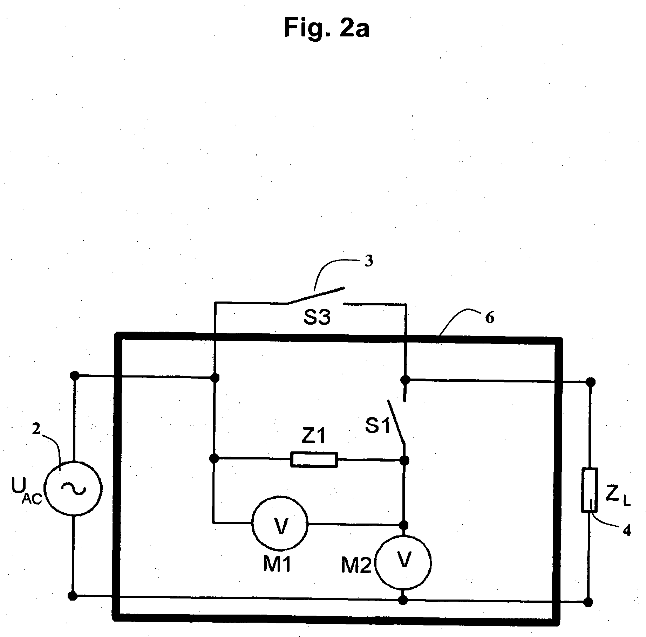

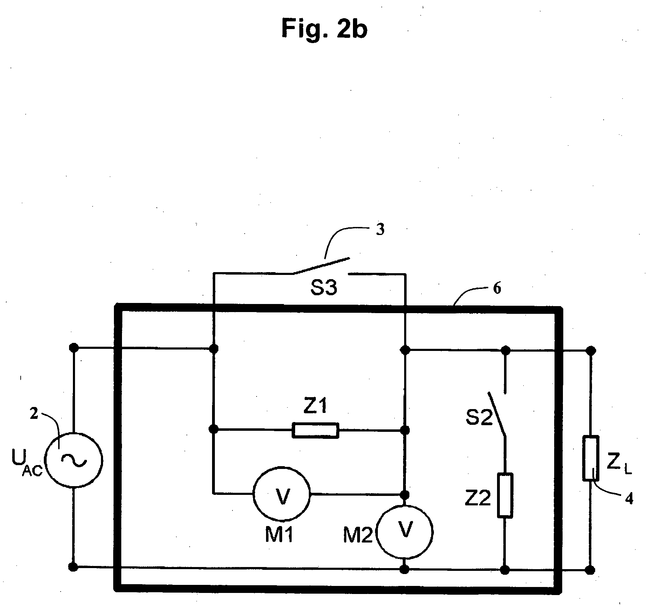

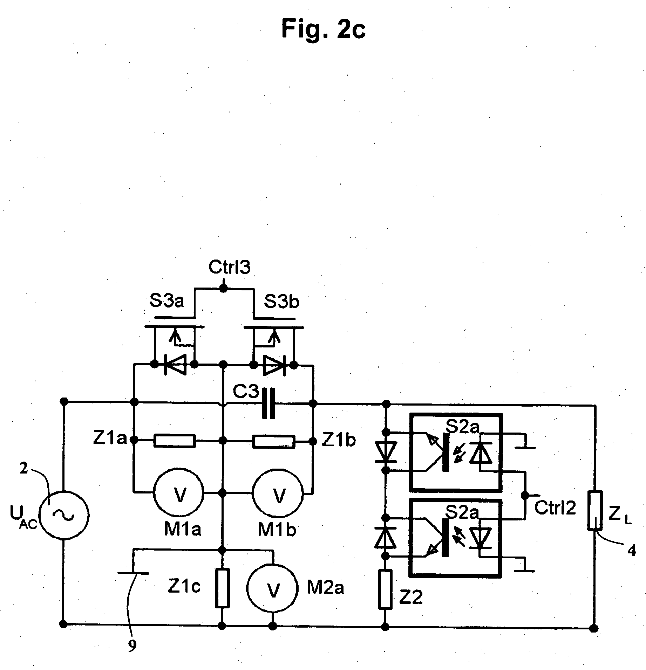

Wie in Fig. 2 gezeigt, ist die Steuervorrichtung 1 mit einem Lastartdetektor 6 ausgestattet. Fig.2a zeigt eine erste mögliche Ausführungsform des Lastartdetektors 6. Hier befindet sich parallel zum Schalter S3, der dem ersten Schalter 3 gemäß Fig. 1 entspricht, eine Reihenschaltung aus der Impedanz Z1 und einem zweiten Schalter S1. In einem ersten Schritt des erfindungsgemäßen Verfahrens wird bei geöffnetem Schalter S3, d.h. bei abgeschalteter Last 4, der zweite Schalter S1 geschlossen, sodass ein Teststrom durch die Last 4 fließt. Dieser Teststrom wird durch geschickte Dimensionierung der Impedanz Z1, z.B. 500 kOhm, auf einen Wert begrenzt, vorzugsweise < 1 mA, der für einen bestimmungsgemäßen Betrieb der Last 4 nicht ausreicht. Der Teststrom soll nicht zu anomalen oder von außen wahrnehmbaren Betriebszuständen der angeschlossenen Last 4 führen, wie z.B. sichtbare Leuchterscheinungen in einer als Last 4 angeschlossenen Leuchte.

Nach einer Ausführungsform der Erfindung kann statt der Impedanz Z1 eine beliebige Vorrichtung zum Einsatz kommen, welche in der Lage ist, den Strom auf den gewünschten Teststrom zu begrenzen (z.B. aktive Transformatoren, passive Bauelemente). Möglich ist hier auch, dass der Teststrom dynamisch eingestellt wird, d.h. in die Detektion der Lastart der Last 4 können Messungen bei verschiedenen Testströmen eingehen. Außerdem können die Impedanzen zur Formung und Begrenzung des Teststroms nicht nur eigens zu diesem Zweck in die erfindungsgemäße Vorrichtung eingebracht werden, sondern als Impedanzen können zu diesem Zweck auch solche eingesetzt werden, die als Bestandteil anderer Baugruppen, wie z.B. des Nullspannungsdetektors 10, sowieso vorhanden sind.

Es sei darauf hingewiesen, dass hier lediglich exemplarisch die beiden Schalter S1 und S3 zur Regelung des von der Spannungsquelle zum Lastkreis fließenden Teststroms, d.h. z.B. zum Ein- und Ausschalten desselben, dargestellt sind. Schalter im Sinne der Erfindung ist jedoch jegliche Art von Steuer- oder Regelvorrichtung, mittels welcher der Stromfluss des Teststroms, als auch ggfs. des Betriebsstroms gesteuert werden kann.

In einem zweiten Schritt des erfindungsgemäßen Verfahrens wird mit Hilfe einer Spannungsmesseinrichtungen M1 eine vom Teststrom abgeleitete erste Größe gemessen und parallel dazu mit Hilfe einer Spannungsmesseinrichtung M2 eine von der Spannung an der Last abgeleitete zweite Größe ermittelt, wobei im Verlaufe einer oder mehrerer Perioden der Netzspannung mit jeder Spannungsmesseinrichtung M1, M2 eine Messreihe mit mehreren Messungen durchgeführt wird, um den Verlauf des Teststroms und der Testspannung abzubilden.

In einem dritten Schritt des Verfahrens untersucht die Steuerschaltung 8 die Messergebnisse aus dem zweiten Schritt des Verfahrens auf bestimmte Merkmale bezüglich des Signalverlaufs. In einer beispielhaften Ausgestaltung des erfindungsgemäßen Verfahrens ermittelt die Steuerschaltung 8 für einen vorbestimmten Zeitraum relativ zu dem Nulldurchgang der Netzspannung, ob z.B. vorgegebene Schwellwerte über- oder unterschritten wurden, oder ob sich der Wert relativ zu dem Wert des gleichen Zeitraums in der letzten Periode verändert hat oder ob die Veränderungsgeschwindigkeit einen vorgegebenen Schwellwert über- oder unterschritten hat.

Die Summe der ermittelten Merkmale ergeben eine Merkmalskombination, welche die Steuerschaltung 8 in einem vierten Schritt des Verfahrens einem Lasttyp zuordnet. Diese Zuordnung erfolgt in einer beispielhaften Ausgestaltung des erfindungsgemäßen Verfahrens durch Vergleich mit Datensätzen eines in der Steuerschaltung 8 gespeicherten Datenfeldes. In einer beispielhaften Ausgestaltung des Erfindungsgegenstands enthält dieses Datenfeld Datensätze für zumindest folgende Lasttypen:
1. keine Last;
2. ohmsche oder induktive Last;
3. elektronischer Transformator zum Betrieb einer Niedervolt-Glühlampe;
4. Energiesparlampe mit elektronischem Vorschaltgerät, nicht dimmbar;
5. Energiesparlampe mit elektronischem Vorschaltgerät, dimmbar;
6. LED-Leuchtmittel, nicht dimmbar;
7. LED-Leuchtmittel, dimmbar.

Bei dem erfindungsgemäßen Verfahren wird nach Abschluss aller Messungen der Schalter S1 wieder geöffnet und so der Teststrom durch die Last 4 abgeschaltet, damit sich in einem eventuell vorhandenen elektronischen Betriebsgerät der Last 4 keine Ladung aufbauen kann, die dann zu anomalen Betriebszuständen der Last 4, wie Leuchtartefakten, welche z.B. die Energiesparlampe des Typs GENIE 8W der Firma PHILIPS zeigt, führen kann.

Zusammengefasst stellt sich damit das erfindungsgemäße Verfahren zur Bestromung der Last 4 wie folgt dar: Zunächst ist der Schalter S3 im Ausgangszustand geöffnet. Durch Schließen des Schalters S1 wird ein geringer Teststrom als Testsignal von der Spannungsquelle 2 zur Last 4 durch die Steuervorrichtung 1 geleitet, wobei der Teststrom so begrenzt ist, dass ein bestimmungsgemäßer Betrieb der Last 4 vermieden wird, wobei das Anlegen des Teststroms zu einer Testspannung an der Last 4 führt. Mittels der Messeinrichtungen M1 und M2 werden daraufhin eine vom Teststrom abgeleiteten erste Größe und eine von der Testspannung abgeleitete zweite Größe über einen vorbestimmten Zeitraum bestimmt, wobei anschließend diese beiden Größen analysiert werden. Aus dem zeitlichen Verlauf der beiden Größen über den vorbestimmten Zeitraum kann nun ermitteln werden, welche Lastart die Last 4 aufweist.

Möglich ist auch, den Energieverbrauch zu ermitteln, wobei das Vorwissen über bestimmte Eigenschaften der Last 4, wie z.B. die nominale Leistungsaufnahme, in die Ermittlung des Energieverbrauchs einbezogen werden kann. Die einzelnen Verfahrensschritte können mehrfach durchgeführt werden und daraus ein Mittelwert der zur Messung des Energieverbrauchs angeschlossenen Last bestimmt werden.

Schließlich wird der Schalter S3 geschlossen, woraufhin der Betriebsstrom in durch die Steuervorrichtung 1 geregelter Weise zur Last 4 fließen kann.

Fig. 2b zeigt eine zweite mögliche Ausführungsform. Hier befindet sich an Stelle des in Fig.2a gezeigten Schalters S1 eine Reihenschaltung aus Schalter S2 und Impedanz Z2, die auch hier zur Verhinderung von durch den Teststrom bedingten, anomalen Betriebszuständen an der eigentlich ausgeschalteten Last 4 dient, indem der Schalter S2 geschlossen wird und so ein Teil des Teststroms durch die Impedanz Z2, z.B. 20 kOhm, fließt und dadurch die durch den Teststrom an der Last 4 hervorgerufene Spannung auf einen Wert unterhalb der Startspannung des elektronischen Betriebsgerätes in der Last 4 begrenzt bleibt.

Fig. 2c zeigt eine dritte beispielhafte Ausführungsform, die funktional der in Fig. 2b gezeigten Variante entspricht und bei der der in Fig. 2b gezeigte Schalter S3 durch zwei MOSFETs S3a und S3b realisiert ist, der Schalter S2 in Form einer Serienschaltung aus zwei Optokopplern S2a und S2b ausgeführt ist und die Impedanz Z1 mittels der Impedanzen Z1a, Z1b, Z1c und C3 verwirklicht ist, die Spannungsmesseinrichtung M1 sich aus den beiden Messeinrichtungen M1 a und M1 b zusammensetzt und die Spannungsmesseinrichtung M2 der Addition der Messeinrichtungen M2a und M1 b entspricht. Besonders vorteilhaft an der Ausführungsform aus Fig. 2c gegenüber der Ausführungsform aus Fig. 2b ist die gemeinsame Signalmasse 9 sowohl der Spannungsmesseinrichtungen M1 a, M1b und M2a, als auch der beiden Steuersignale Ctrl2 und Ctrl3, wodurch diese Signale ohne großen Aufwand mit der Steuerschaltung 8, insbesondere mit dem darin enthaltenen Mikrokontroller, verbunden werden können und die Spannungsmesseinrichtungen M1 a, M1b und M2a in Form einer einzelnen Spannungsmesseinrichtung mit davor geschaltetem Signalmultiplexer realisiert werden können.

In der beispielhaften Ausgestaltung der erfindungsgemäßen Vorrichtung nach Fig. 2c sind die Impedanzen Z1 a, Z1 b, Z1c und C3 nicht notwendigerweise eigens in die erfindungsgemäße Vorrichtung eingebracht, sondern sind dort bereits Bestandteil anderer Baugruppen. Die Impedanzen Z1 a und Z1 c können beispielsweise Bestandteil des Nullspannungsdetektors 10 sein und dort den Eingangsstrom des Komparators begrenzen. In einer speziellen beispielhaften Ausgestaltung sind die Impedanzen durch Widerstände realisiert, welche die Eingangsströme der Steuerschaltung 8 und des Nullspannungsdetektors 10 begrenzen. Ebenso beeinflusst die in Fig. 2c gezeigte Kapazität C3 den Teststrom. Die Werte der Komponenten betragen z.B. Z1 a = 400 kOhm, Z1 b = 1000 kOhm, Z1 c = 700 kOhm und C3 = 1nF.

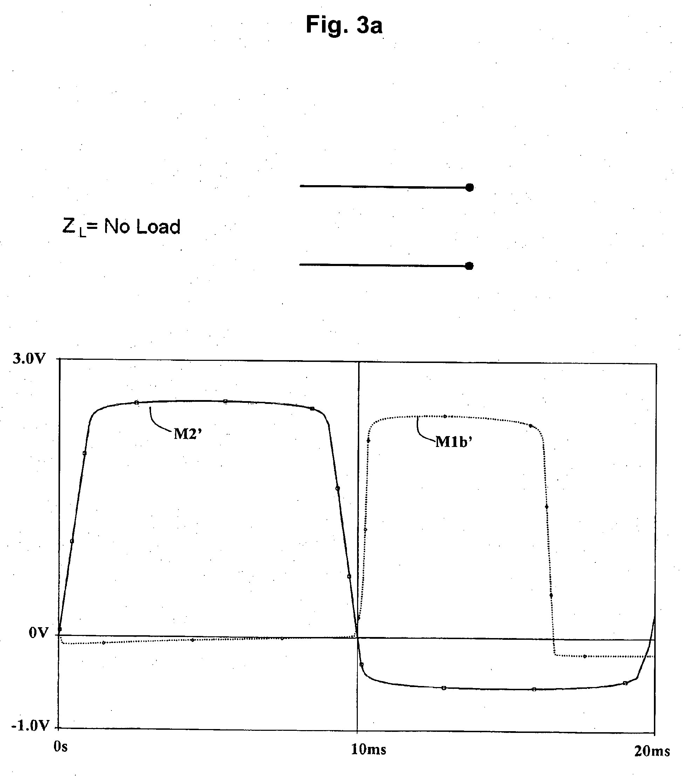

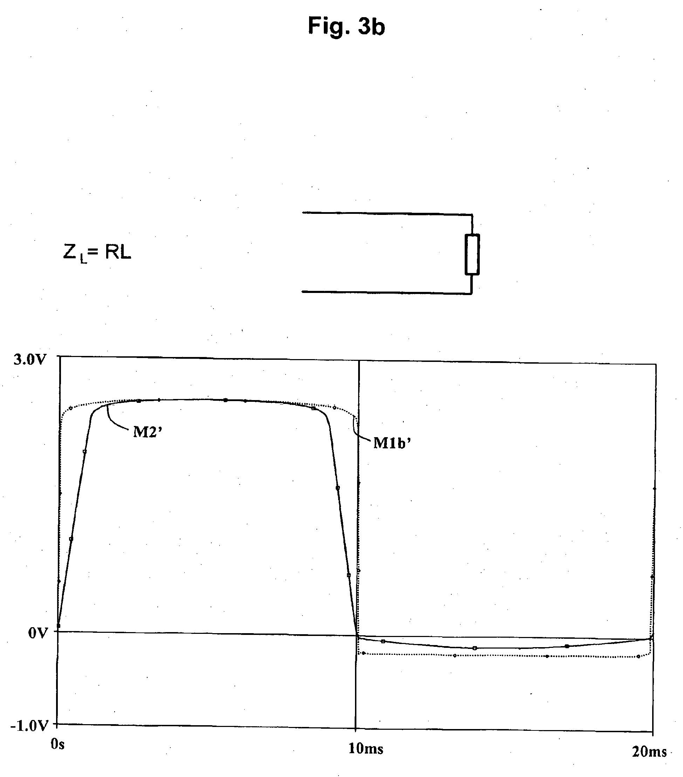

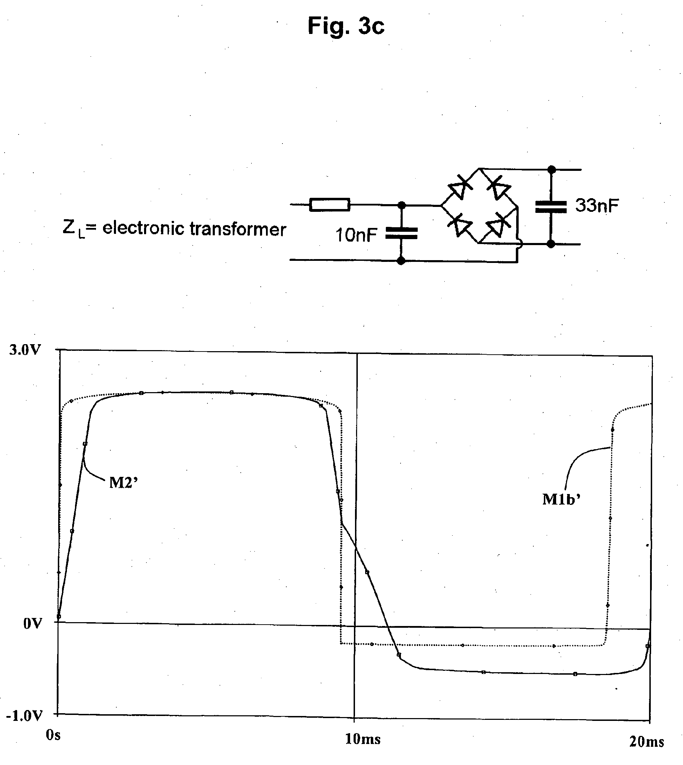

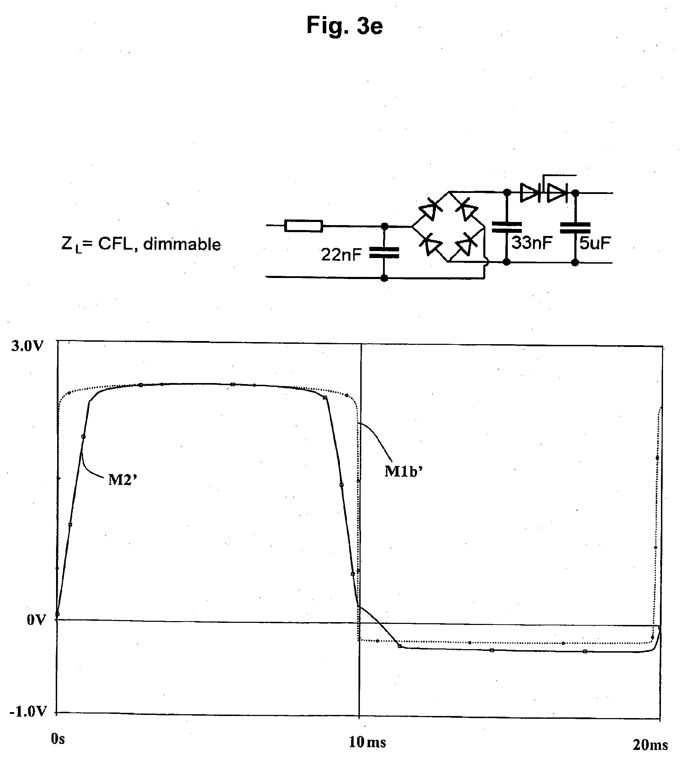

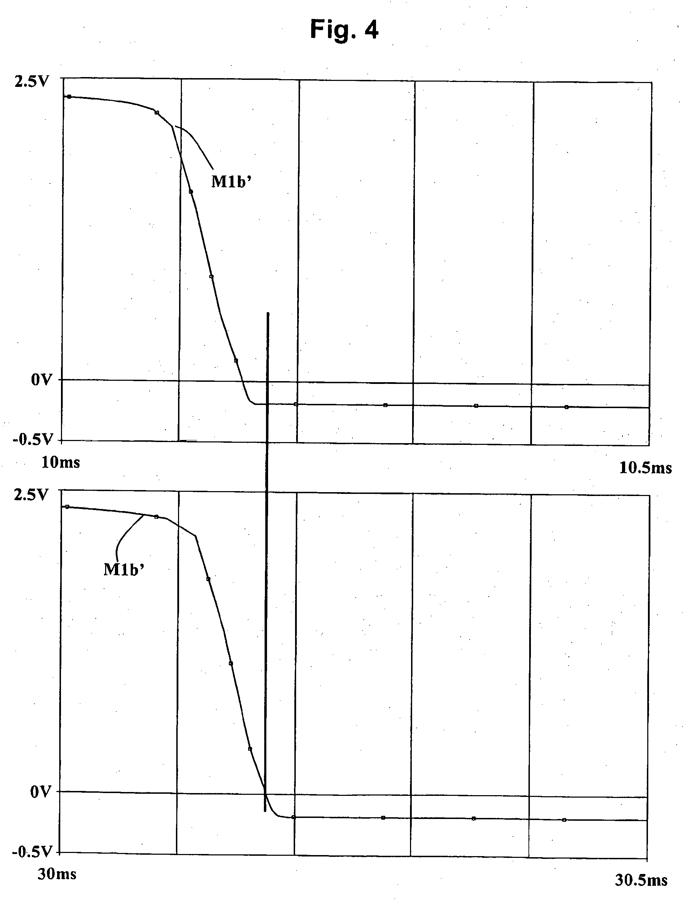

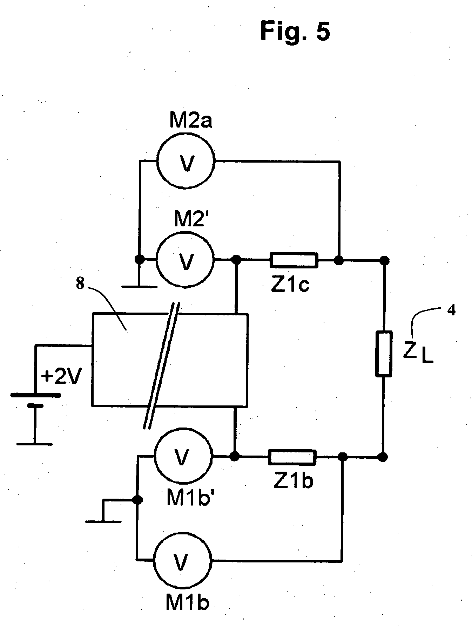

Fig. 3a bis Fig. 3e zeigen die Eingangsbeschaltung beispielhafter Lasttypen, die von der erfindungsgemäßen Vorrichtung und dem Verfahren unterschieden werden, weil jeder Lasttyp eine charakteristische Eingangsbeschaltung aufweist, die den Teststrom in einer anderen Weise beeinflusst und somit auch unterschiedliche Signalverläufe an den Spannungsmesseinrichtungen M1a, M1b und M2 hervorruft. In den Fig. 3a bis 3e sind zugehörig zu der jeweiligen Eingangsbeschaltung der Last 4 beispielhafte Signalverläufe M1b' und M2' für jeweils eine Periode der Netz-Wechselspannung von 50Hz aufgezeigt, wie sie mittels der Steuerschaltung 8 entsprechend Fig. 5 gemessen werden. Fig. 4 zeigt, dass sich Merkmale im Signalverlauf über mehrere Perioden der Wechselspannung ändern können. In dem gezeigten Beispiel wechselt das von der Spannungsmesseinrichtung erfasste Signal M1b' die Polarität mit steigendem zeitlichen Abstand zum Zeitpunkt des Nulldurchgangs der 50Hz Wechselspannung. Im oberen bzw. unteren Ausschnitt der Fig. 4 findet der Nulldurchgang bei 10ms bzw. 30ms statt und die Polaritätsänderung etwa 150us bzw. 170us später, d.h. der zeitliche Abstand zwischen Nulldurchgang und Polaritätswechsel von M1b' erhöht sich pro Periode um etwa 20us.

Spätestens nach Beendigung der Messungen untersucht die Steuerschaltung 8 die gemessenen Signalverläufe auf Merkmale, die vorteilhaft so gewählt werden, dass deren Berechnung nur wenige ms Rechenzeit auf einem handelsüblichen 8-Bit-Mikrokontroller benötigt. Für die in Fig. 3a bis 3e gezeigten Signalverläufe können beispielsweise folgende Merkmale MM1 bis MM5 zur Detektion der Lastart gewählt werden:
Merkmal MM1: M1b' zum Zeitpunkt T=15ms > 1V
Merkmal MM2: M1b' zum Zeitpunkt T=10ms > 1 V
Merkmal MM3: M2' zum Zeitpunkt T=10ms >0.5V
Merkmal MM4: M1b' zum Zeitpunkt T=19.9ms>1V
Merkmal MM5: M2' zum Zeitpunkt T=10ms >1V

Die Merkmale sind so gewählt, dass jede Lastart eine oder mehrere eindeutige Merkmalskombinationen aufweist. In der Steuerschaltung 8 ist die Zuordnung zwischen Merkmalskombination und Lastart in Form eines Datenfeldes gespeichert ist, sodass die Ermittlung der Lastart entsprechend einfach möglich ist.

Die folgende Tabelle zeigt ein beispielhaftes Datenfeld zur Zuordnung einer Merkmalskombination zu einem Lasttyp:

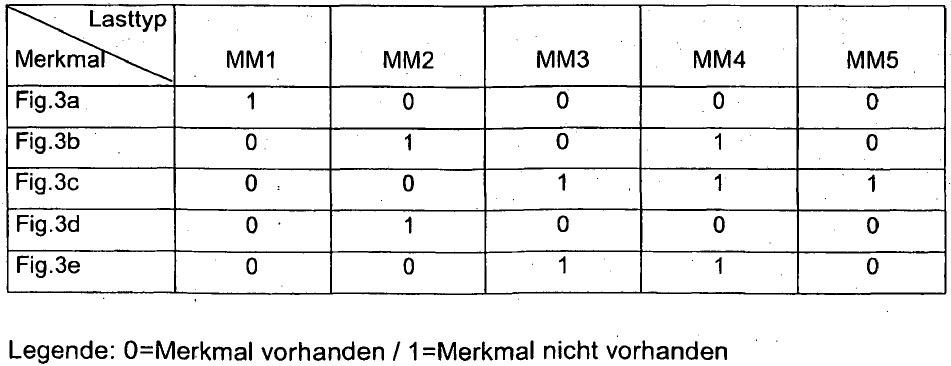

Es ist möglich, die Liste der detektierbaren Lasten um weitere Lastarten zu ergänzen, indem für jede weitere Lastart die relevanten Messungen durchgeführt werden und z.B. durch augenscheinlichen Vergleich der Messkurven eine Merkmalsextraktion durchführt wird und dann das Datenfeld in der Software der Steuerschaltung 8 entsprechend angepasst oder erweitert wird. Möglich ist es auch, eine Selbstlernfunktion für neue Lasten, ggf. nach genauerer Spezifizierung durch den Anwender, zu implementieren.

Es ist vorteilhaft im Sinne eines möglichst geringen Datenvolumens aus der Messung und einer einfachen und schnellen Verarbeitung der Messwerte in der Steuerschaltung 8, nur während solcher Zeiträume innerhalb einer Periode Messungen durchzuführen, in denen die entscheidungsrelevanten Signalverläufe stattfinden, z.B. nahe der Nulldurchgänge und in der Mitte der Halbwelle der Wechselspannung, anstatt äquidistant über die gesamte Messperiode verteilt Messungen durchzuführen.

Ebenso vorteilhaft ist es im Sinne möglichst geringer Produktionskosten der erfindungsgemäßen Steuervorrichtung, dass an die absolute Genauigkeit, Linearität oder Auflösung der Spannungsmesseinrichtungen nur geringe Anforderungen gestellt werden, sodass die Spannungsmesseinrichtungen lediglich mindestens eine solche Wiederholgenauigkeit aufweisen, dass die aus den Signalverläufen abgeleiteten Merkmale aufgrund der Wiederholgenauigkeit nicht entscheidungsrelevant variieren.

Nachdem die Steuerschaltung 8 die ermittelte Merkmalskombination einem Datensatz zuordnen und damit die Lastart ermitteln konnte, wird sie zunächst überprüfen, ob die ermittelte Lastart der in Fig. 3a dargestellten Art entspricht, d.h. keine Last an die Steuervorrichtung 1 angeschlossen ist, und in diesem Fall den Teststrom aktiviert lassen und das erfindungsgemäße Verfahren beginnend mit dem zweiten Schritt erneut durchführen. Die in Fig. 3a dargestellte Lastart "keine Last" kann auch einer Last entsprechen, die nicht zum Anschluss an die Steuervorrichtung 1 vorgesehen ist, z.B. einem hochohmigen Widerstand von z.B. einem Megaohm.

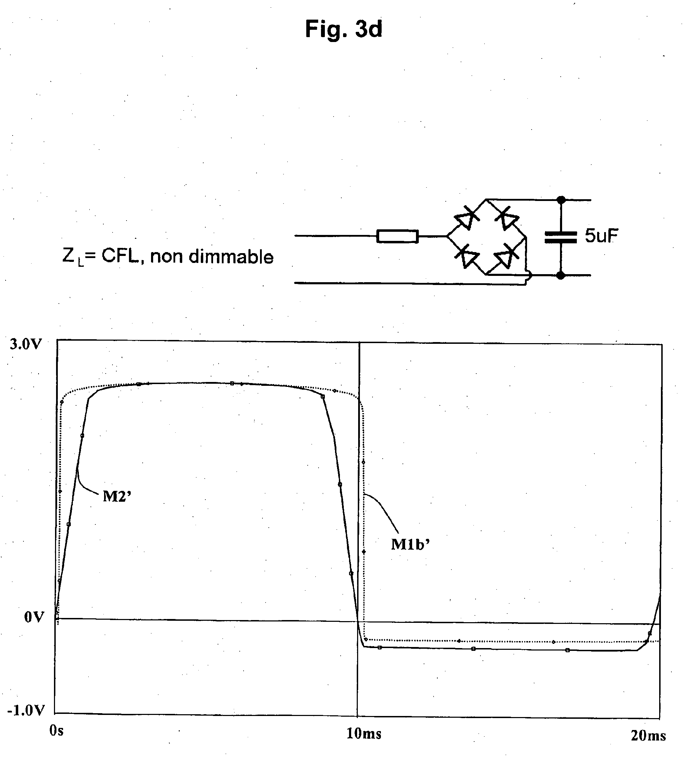

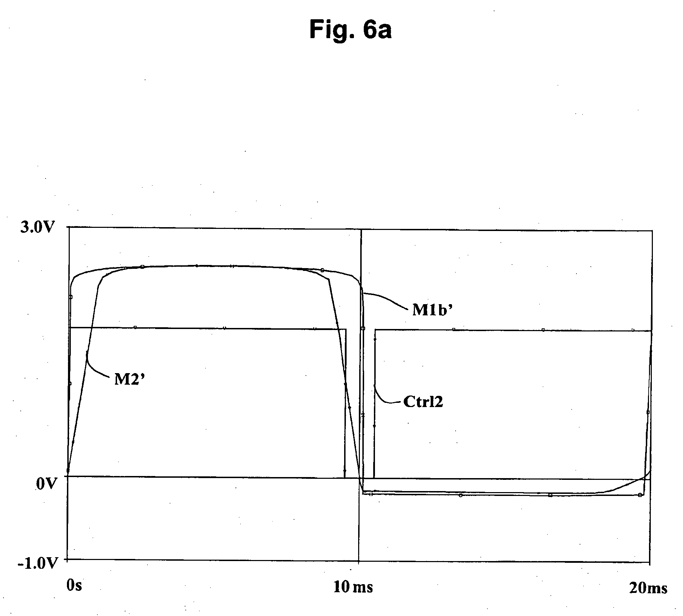

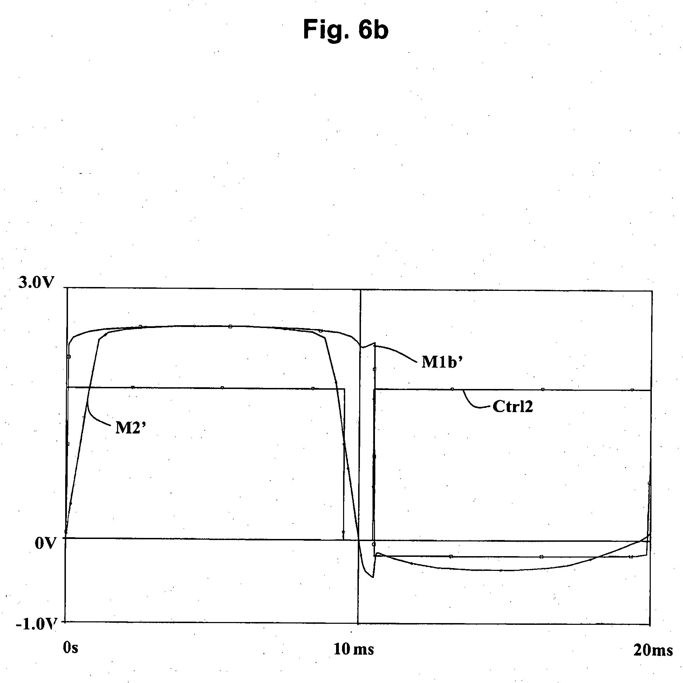

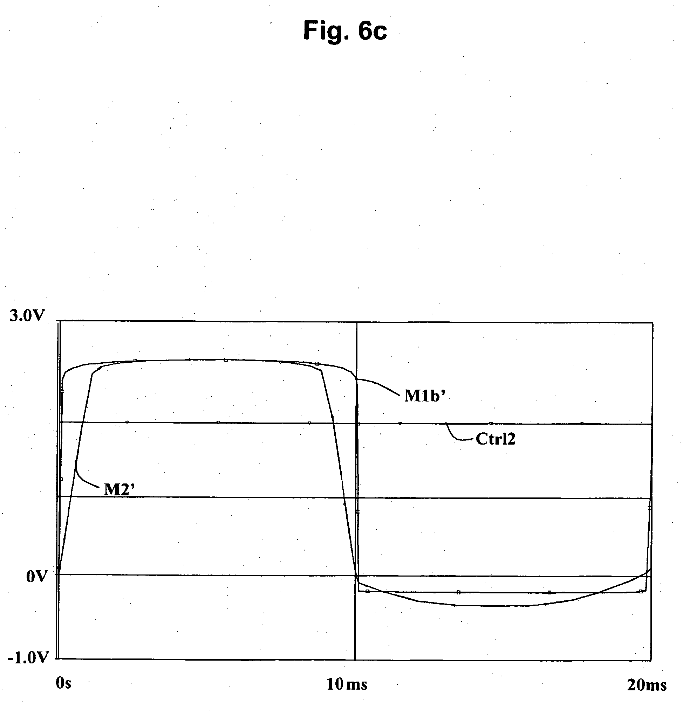

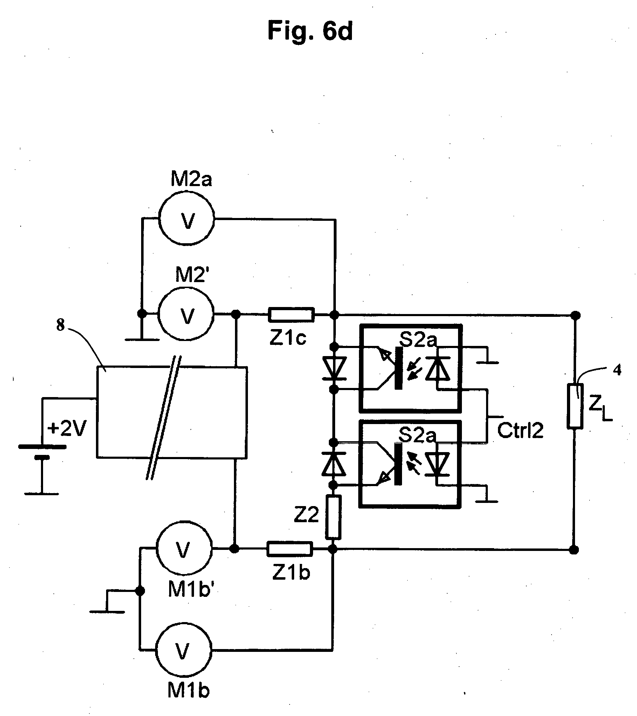

Andernfalls, wenn die ermittelte Lastart nicht der in Fig.3a dargestellten Variante entspricht, sondern es sich bei der Lastart um eine Variante handelt, die aufgrund des Teststroms ungewünschte Reaktionen zeigt, wie z.B. die in Fig. 3d dargestellte Lastart, wird die Steuerschaltung 8 den Teststrom durch die Last unterbrechen oder reduzieren, indem sie beispielsweise im Fall der Ausführungsvariante nach Fig. 2c den dort gezeigten Optokoppler durch einen positiven Steuerstrom am Anschluss Ctrl2 aktiviert und so die durch den Teststrom an der Last hervorgerufene Spannung auf einen Wert von z.B. 20 V begrenzt. Damit die Steuerschaltung 8 trotz abgeschaltetem oder reduziertem Teststrom das Trennen der Verbindung zwischen Last 4 und Steuervorrichtung 1 erkennt, kann die Steuerschaltung 8 besonders vorteilhaft diese Unterbrechung oder Reduktion des Teststroms innerhalb eines Zeitraums, in dem dessen momentaner Wert besonders niedrig ist, z.B. in der Nähe des Spannungsnulldurchgangs der Spannungsquelle 2, für einen kurzen Zeitraum wieder aufheben. Hierzu zeigen die Fig. 6a bis Fig. 6c für eine Lastart entsprechend Fig. 3d beispielhafte Signalverläufe M1b', M2' und Ctrl2 für jeweils eine Periode der Wechselspannung von 50Hz, wie sie an der Steuerschaltung 8 entsprechend Fig. 6d bei geöffnetem Schalter 3 auftreten, wobei Fig. 6a die Signalverläufe für den Fall darstellt, dass die Last 4 mit der Steuervorrichtung 1 verbunden ist, die Fig. 6b die Signalverläufe für den Fall darstellt, dass dieselbe Last 4 entfernt wurde, wobei in Fig. 6c unterschiedlich zu Fig. 6b der Teststrom nicht abgesenkt wurde. Der Vergleich der Fig. 3d mit der Fig. 6a und der Fig. 6b mit der Fig. 6c zeigt, dass das Entfernen der Last 4 anhand des Signals M1b' erkannt werden kann.

Vorteilhaft im Sinne der Erfindung ist es auch, wenn jedem Lasttyp spezifische Steuerparameter zugeordnet werden können, wie z.B.:
- Steuermethode, wie z.B. Phasenanschnitt, Phasenabschnitt, nur Ein/Aus, etc.;
- Minimalwert und Maximalwert für z.B. Leistung oder Phasenwinkel;
- Steuerkurve, z.B. zum Ausgleich eines nicht-linearen Zusammenhangs zwischen Phasenwinkel und Helligkeit bei Leuchtmitteln;
- Zeitabhängige Grenzwerte, z.B. minimale Einschalthelligkeit bei Entladungslampen;
- Information, ob eine Reduktion des Teststroms nach Erkennen der Last erforderlich ist.

Diese Steuerparameter können in der Tabelle im gleichen Datensatz gespeichert werden, der auch die Merkmalskombination zur Erkennung der Last enthält.

Weiterhin vorteilhaft im Sinne der Erfindung führt die Steuerschaltung 8 beim Erkennen des Ereignisses, dass eine elektrische Verbindung zur Last 4 hergestellt wurde oder dass eine solche Verbindung getrennt wurde, eine Aktion aus, z.B. das Einschalten der Last 4, oder übermittelt diese Information über die Kommunikationseinheit 5 an weitere Geräte, die darauf hin eine Aktion ausführen können. Für den Fall, dass es sich bei der Last 4 um eine Leuchte handelt, kann es gewünscht sein, diese automatisch einzuschalten, sobald eine elektrische Verbindung zwischen Leuchte und Steuervorrichtung 1 hergestellt wird, um so einen eventuell vorhandenen Bedienschalter in der Leuchte aus der Sicht des Anwenders funktionsfähig zu halten. Es ist sinnvoll, die Überprüfung der elektrischen Verbindung zwischen Steuervorrichtung 1 und Last 4 in kurzen Zeitabständen wiederholt durchzuführen, z.B. alle 100ms, damit aus Sicht des Anwenders die Reaktion auf das der Herstellung der Verbindung zugeordnete Steuerereignis verzögerungsfrei ist.

In einer ganz besonders vorteilhaften Ausgestaltung der erfindungsgemäßen Steuervorrichtung 1 ist diese so konstruiert, dass die Zeitdauer vom Herstellen einer elektrischen Verbindung zwischen der Spannungsquelle 2 und der Steuervorrichtung 1 über das Bestimmen der Lastart einer mit der Steuervorrichtung verbundenen Last 4, bis zum möglichen Einschalten dieser Last, vom Anwender nicht als störende Verzögerung wahrgenommen wird (z.B. Zeitdauer < 200ms). Dies wird erreicht, indem beispielsweise die Stromversorgung 7 so konstruiert wird, dass die Steuervorrichtung 1 spätestens 100ms nachdem diese mit der Spannungsquelle 2 verbunden wurde, betriebsbereit ist und dann die Steuerschaltung 8 mit der Durchführung des erfindungsgemäßen Verfahrens direkt beginnen kann. Dadurch ist es möglich, dass ein Installationsschalter, der sich elektrisch in Serie zu der Steuervorrichtung 1 befindet, aus Sicht des Anwenders funktionsfähig bleibt und die Steuervorrichtung 1 das Betätigen des Installationsschalters über die Kommunikationseinheit 5 an weitere Geräte übermitteln kann, die darauf hin eine Aktion ausführen können. Z.B. kann so mit dem Betätigen des Installationsschalters gleichzeitig eine weitere Leuchte eingeschaltet werden, die mit einer weiteren Steuervorrichtung 1 verbunden ist.

Nach dem Erkennen der Last 4 und der dazugehörigen Lastart kann die Steuervorrichtung 1 die Last 4 auf Anforderung einschalten. Diese Anforderung kann beispielsweise durch ein Datenpaket ausgelöst werden, das von der Kommunikationseinheit 5 empfangen wird.

In einer besonders vorteilhaften Ausgestaltung der Erfindung ermittelt die Steuerschaltung 8 in einem weiteren Schritt des erfindungsgemäßen Verfahrens, durch Messung und Auswertung des Betriebsstroms beim Einschalten und in der Zeit nach dem Einschalten der Last 4, zusätzliche Informationen über dieselbe. Besonders hilfreich ist diese Zusatzinformation wenn es sich bei der Last 4 um ein elektronisches Betriebsgerät handelt, wie es beispielsweise bei einer Energiesparlampe oder einem LED-Leuchtmittel gegeben ist, da sich bei dieser Lastart die notwendigen Parameter zur ordnungsgemäßen Steuerung der Last 4 im Wesentlichen aus der Konstruktion des elektronischen Betriebsgeräts ergeben und beispielsweise Energiesparlampen abhängig von Typ und Hersteller unterschiedlich konstruierte Betriebsgeräte aufweisen.

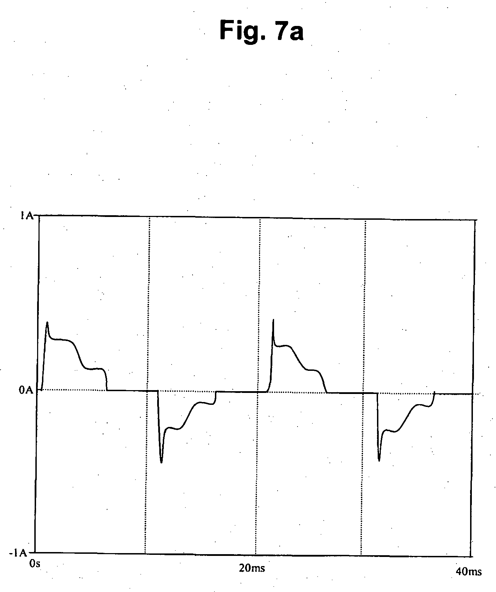

Zur Durchführung dieses zusätzlichen Schritts zur Detektion der Lastart im Sinne der Erfindung wird die Steuerschaltung 8 die Last 4 zu einem festgelegten Zeitpunkt innerhalb der Periode der Netzspannung, z.B. zum Zeitpunkt des Nulldurchgangs der Spannung, einschalten, und ab dann über eine oder mehrere Perioden der Netzspannung den Verlauf des Betriebsstroms messen. In der beispielhaften Ausgestaltung der erfindungsgemäßen Steuervorrichtung 1 nach Fig. 2c wird der Betriebsstrom mit Hilfe der Messeinrichtungen M1 a und M1 b ermittelt, wobei der Spannungsabfall am Bahnwiderstand der dort gezeigten MOSFETs S3a und S3b den Betriebsstromverlauf abbildet. In Fig. 7a bis Fig. 7d ist beispielhaft der Betriebsstromverlauf, gemessen ab dem Zeitpunkt des Einschaltens im Nulldurchgang der Netzspannung, für die folgenden Lastarten aufgezeigt:
- Fig. 7a:: Energiesparlampe mit elektronischem Vorschaltgerät, nicht dimmbar, MEGAMAN GA607 oder PHILIPS Genie;

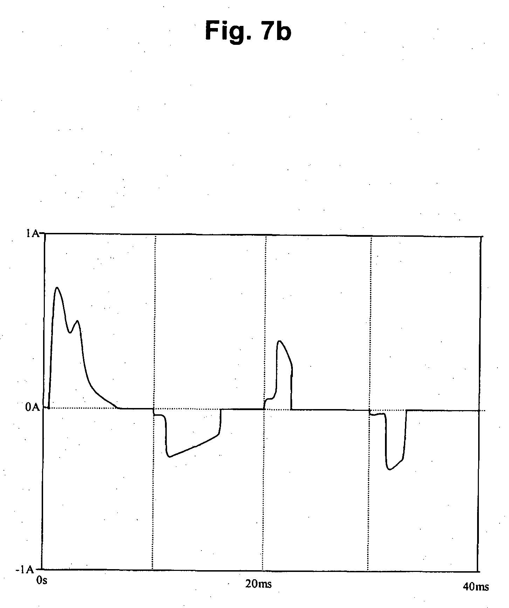

- Fig. 7b:: Energiesparlampe mit elektronischem Vorschaltgerät, dimmbar, OSRAM, DULUX EL DIMMABLE 20W;

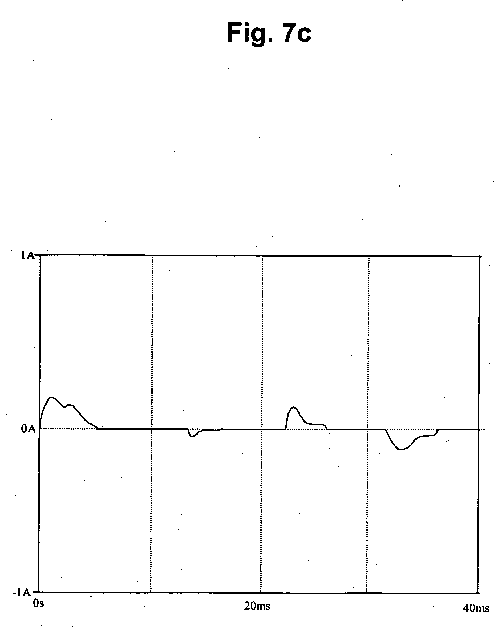

- Fig. 7c:: LED-Leuchtmittel, dimmbar PHILIPS MASTER LED Spot MV 7W.

Zur Unterscheidung der Leuchtmittel entsprechend der Fig. 7a bis 7c wird der gemessene Betriebsstromverlauf auf bestimmte Merkmale untersucht. Beispielhaft könnten folgende Merkmale untersucht werden, die für jede Halbwelle der Netzspannung bestimmt werden:
- Merkmal MM6:: Zeitdauer vom letzten Nulldurchgang der Netzspannung bis zum Beginn des Stromflusses;
- Merkmal MM7:: Zeitdauer des Stromflusses.

Die Ergebnisse der Auswertung dieser beispielhaften Merkmale für die Stromverläufe entsprechend den Fig. 7a bis 7c zeigt die folgende Tabelle:

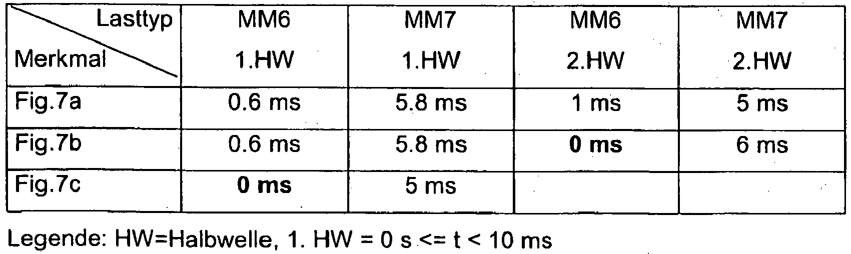

Die Steuerschaltung 8 kann anhand der fett gedruckten Werte in der Tabelle spätestens in der zweiten Halbwelle der Netzspannung nach dem Einschalten der Last 4 deren Lastart erkennen.

Weitere Merkmale, die zur Unterscheidung der Betriebsstromverläufe bei einer größeren Anzahl verschiedener Lastarten untersucht werden können, sind:
- die Anzahl der Maxima und Minima im Stromkurvenverlauf;
- die Änderung der Steigung der Stromverlaufskurve über- oder unterschreitet einen Grenzwert;
- das Maximum des Stroms innerhalb eines zeitlichen Fensters.

Die Anzahl verschiedener Konstruktionsprinzipien für elektronische Betriebsgeräte von Energiesparlampen oder LED-Leuchtmitteln ist insofern begrenzt, als einzelne Hersteller nur wenige (z.B. drei) verschiedene Konstruktionsprinzipien im Rahmen ihrer gesamten Produktpalette verwenden, und so die Gesamtzahl der Unterscheidungen im Rahmen des fünften Schritts des erfindungsgemäßen Verfahrens überschaubar ist.

Zusätzlich besonders vorteilhaft führt die Steuerschaltung 8 den zuletzt beschriebenen Schritt der Lastart-Erkennung nur bei bestimmten Lastarten durch, z.B. bei Energiesparlampen und LED-Leuchtmitteln. Dadurch wird vermieden, dass Lastarten, die für diese Variante des erfindungsgemäßen Verfahrens ungeeignet sind, z.B. Glühlampen, kein störendes Verhalten beim Einschalten der Last 4, wie z.B. ein kurzes Aufblitzen, zeigen.

Weiterhin besonders vorteilhaft ist die Ausgestaltung der Erfindung derart, dass die zur Durchführung des erfindungsgemäßen Verfahrens vorgesehenen Messeinrichtungen zur Ermittlung des Energieverbrauchs der Last eingesetzt werden, indem beispielsweise bei der erfindungsgemäßen Ausgestaltung nach Fig. 2c bei geschlossenem Schalter 3 der zur Berechnung des Energieverbrauchs benötigte Wert der Spannung an der Last 4 durch Kombination der Anzeigewerte der Messeinrichtungen M1a und M2a bestimmt wird und der zur Berechnung des Energieverbrauchs benötigte Wert des Betriebsstroms durch Kombination der Anzeigewerte der Messeinrichtungen M1b und M2a ermittelt wird.

### Bezugszeichenliste

- (1): Steuervorrichtung
- (2): Spannungsquelle
- (3): erster Schalter
- (4): Last
- (5): Kommunikationseinheit
- (6): Lastartdetektor
- (7): Stromversorgung
- (8): Steuerschaltung
- (9): Signalmasse
- (10): Nullspannungsdetektor

## Patentansprüche

1. Steuervorrichtung (1) zur Steuerung einer Last (4), wobei die Steuervorrichtung (1) zwischen eine Spannungsquelle (2) und die Last (4) schaltbar ist, mit einer Steuerschaltung (8), einem von der Steuerschaltung (8) angesteuerten ersten Schalter (S3), der einen von der Spannungsquelle (2) zur Last (4) fließenden Strom zum Betrieb der Last (4) steuert, und einem Lastartdetektor (6), wobei der Lastartdetektor (6) Mittel (Z1, Z2, S1, S2) zur Beaufschlagung der Last (4) mit einem Testsignal und wenigstens eine Messeinrichtung (M1, M2) umfasst, wobei die Steuervorrichtung (1) zum Zwecke der Detektion der Lastart der Last (4) eingerichtet ist, die folgenden ersten Detektionsschritte auszuführen:
- Ansteuerung der Mittel (Z1, Z2, S1, S2) zur Beaufschlagung der Last (4) mit dem Testsignal durch die Steuerschaltung (8) bei geöffnetem ersten Schalter (S3), wobei die Beaufschlagung mit dem Testsignal zu einem durch die Last (4) fließenden Teststrom und einer an der Last (4) abfallenden Testspannung führt,
- Erfassung wenigstens einer von dem Teststrom und/oder der Testspannung abgeleiteten ersten Größe durch die Messeinrichtung (M1, M2),
**dadurch gekennzeichnet, dass** die Steuervorrichtung (1) eingerichtet ist, die folgenden weiteren Detektionsschritte auszuführen:
- Beaufschlagung der Last (4) mit einem Betriebsstrom durch Schließen des ersten Schalters (S3),
- Erfassung wenigstens einer von dem Betriebsstrom und/oder der an der Last abfallenden Betriebsspannung abgeleiteten zweiten Größe durch die wenigstens eine Messeinrichtung (M1, M2),
- Detektion der Lastart durch Analyse des zeitlichen Verlaufs der ersten und der zweiten Größe.

2. Steuervorrichtung nach Anspruch 1, **dadurch gekennzeichnet, dass** im Anschluss an die Durchführung der ersten Detektionsschritte der Teststrom unterbrochen oder reduziert wird.

3. Steuervorrichtung nach Anspruch 2, **dadurch gekennzeichnet, dass** die Steuervorrichtung eingerichtet ist, im Anschluss an die ersten Detektionsschritte die folgenden zweiten Detektionsschritte auszuführen:
- Aufhebung der Unterbrechung bzw. der Reduktion des Teststroms während eines vorgegebenen Zeitintervalls bei weiterhin geöffnetem ersten Schalter (S3),
- Erfassung der wenigstens einen von dem Teststrom und/oder der Testspannung abgeleiteten ersten Größe durch die Messeinrichtung (M1, M2) während der Aufhebung der Unterbrechung bzw. der Reduktion des Teststroms,
- Detektion einer Trennung und/oder einer Wiederherstellung der Verbindung zwischen Steuervorrichtung (1) und Last (4) durch Analyse der erfassten ersten Größe.

4. Steuervorrichtung nach Anspruch 1 oder 2, **dadurch gekennzeichnet, dass** die Steuervorrichtung eingerichtet ist, die folgenden zweiten Detektionsschritte auszuführen:
- Ansteuerung der Mittel (Z1, Z2, S1, S2) zur Beaufschlagung der Last (4) mit dem Testsignal durch die Steuerschaltung (8) bei geöffnetem ersten Schalter (S3),
- Erfassung der wenigstens einen von dem Teststrom und/oder der Testspannung abgeleiteten ersten Größe durch die Messeinrichtung (M1, M2),
- Detektion einer Trennung und/oder einer Herstellung der Verbindung zwischen Steuervorrichtung (1) und Last (4) durch Analyse der ersten Größe.

5. Steuervorrichtung nach einem der Ansprüche 1 bis 4, **dadurch gekennzeichnet, dass** der Teststrom während der ersten und/oder zweiten Detektionsschritte in der Weise begrenzt ist, dass ein bestimmungsgemäßer Betrieb der Last (4) unterbleibt.

6. Steuervorrichtung (1) nach einem der Ansprüche 1 bis 5, **dadurch gekennzeichnet, dass** die Steuervorrichtung (1) ferner dazu eingerichtet ist, durch die Steuerschaltung (8) nach Detektion der Lastart einen von der Spannungsquelle (2) zur Last (4) fließenden Strom zum Betrieb der Last durch Ansteuerung des ersten Schalters (S3) gemäß einer der Lastart zugeordneten Steuermethode zu steuern.

7. Steuervorrichtung (1) nach einem der Ansprüche 1 bis 6, ferner **gekennzeichnet durch** eine mit der Steuerschaltung (8) verbundene Kommunikationseinheit (5), wobei die Kommunikationseinheit (5) zum Empfang von Fernsteuerdaten zur Fernsteuerung der Steuervorrichtung (1) und/oder zum Senden von Zustands- und/oder Diagnosedaten der Steuervorrichtung (1) ausgebildet ist.

8. Steuervorrichtung (1) nach einem der Ansprüche 1 bis 7, ferner **gekennzeichnet durch** einen Nullspannungsdetektor (10) zur Detektion von Spannungsnulldurchgängen der mit der Steuervorrichtung (1) verbundenen Spannungsquelle (2), wobei der Zeitpunkt des Beginns der Erfassung der wenigstens einen von dem Teststrom und/oder der Testspannung abgeleiteten ersten Größe **durch** die Messeinrichtung (M1, M2) relativ zum Zeitpunkt eines detektierten Spannungsnulldurchgangs vorgegeben ist.

9. Steuervorrichtung (1) nach einem der Ansprüche 1 bis 8, **dadurch gekennzeichnet, dass** die Steuervorrichtung (1) weiter eingerichtet ist, das Schließen des ersten Schalters (S3) in vorgegebenem zeitlichem Abstand vom Zeitpunkt eines detektierten Spannungsnulldurchgangs durchzuführen.

10. Verfahren zur Detektion der Lastart einer Last (4), insbesondere unter Verwendung einer Steuervorrichtung nach einem der Ansprüche 1 bis 9, wobei die Last (4) über einen ersten Schalter (S3), der einen zur Last (4) fließenden Strom zum Betrieb der Last (4) steuert, mit einer Spannungsquelle (2) verbindbar ist, mit den folgenden ersten Detektionsschritten:
- Beaufschlagung der Last (4) mit einem Testsignal bei geöffnetem ersten Schalter (S3), wobei die Beaufschlagung mit dem Testsignal zu einem durch die Last (4) fließenden Teststrom und einer an der Last (4) abfallenden Testspannung führt,
- Erfassung wenigstens einer von dem Teststrom und/oder der Testspannung abgeleiteten ersten Größe,
**dadurch gekennzeichnet, dass** das Verfahren die folgenden weiteren Detektionsschritte umfasst:
- Beaufschlagung der Last (4) mit einem Betriebsstrom durch Schließen des ersten Schalters (S3),
- Erfassung wenigstens einer von dem Betriebsstrom und/oder der an der Last abfallenden Betriebsspannung abgeleiteten zweiten Größe,
- Detektion der Lastart durch Analyse des zeitlichen Verlaufs der ersten und der zweiten Größe.

11. Verfahren nach Anspruch 10, **dadurch gekennzeichnet, dass** der Teststrom nach Durchführung der ersten Detektionsschritte unterbrochen oder reduziert wird.

12. Verfahren nach Anspruch 10 oder 11, **gekennzeichnet durch** die folgenden zweiten Detektionsschritte:
- Beaufschlagung der Last (4) mit dem Testsignal bei geöffnetem ersten Schalter (S3),
- Erfassung der wenigstens einen von dem Teststrom und/oder der Testspannung abgeleiteten ersten Größe,
- Detektion einer Trennung oder einer Herstellung einer Verbindung zur Last (4) **durch** Analyse der erfassten ersten Größe.

13. Verfahren nach einem der Ansprüche 10 bis 12, **dadurch gekennzeichnet, dass** der Teststrom während der ersten und/oder zweiten Detektionsschritte in der Weise begrenzt ist, dass ein bestimmungsgemäßer Betrieb der Last (4) unterbleibt.

14. Computerprogrammprodukt mit von einem Prozessor ausführbaren Instruktionen zur Durchführung der Detektionsschritte des Verfahrens nach einem der Ansprüche 10 bis 13.

## Claims

1. Control apparatus (1) for controlling a load (4), wherein the control apparatus (1) can be connected between a voltage source (2) and the load (4), having a control circuit (8), a first switch (S3) which is driven by the control circuit (8) and controls a current flowing from the voltage source (2) to the load (4) in order to operate the load (4), and a load type detector (6), wherein the load type detector (6) comprises means (Z1, Z2, S1, S2) for applying a test signal to the load (4) and at least one measuring device (M1, M2), wherein, for the purpose of detecting the type of load (4), the control apparatus (1) is set up to carry out the following first detection steps:
- driving of the means (Z1, Z2, S1, S2) for applying the test signal to the load (4) by means of the control circuit (8) with the first switch (S3) open, wherein the application of the test signal results in a test current flowing through the load (4) and in a test voltage being dropped across the load (4),
- recording of at least one first variable derived from the test current and/or the test voltage by means of the measuring device (M1, M2),
**characterized in that** the control apparatus (1) is further set up to carry out the following further detection steps:
- applying an operating current to the load (4) by closing the first switch (S3),
- recording at least one second variable derived from the operating current and/or the operating voltage dropped across the load by means of the at least one measuring device (M1, M2),
- detection of the type of load by analyzing the temporal course of the first and second variables.

2. Control apparatus according to claim 1, **characterized in that** the test current is interrupted or reduced subsequent to executing the first detection steps.

3. Control apparatus according to claim 2, **characterized in that** the control apparatus is set up to carry out the following second detection steps subsequent to the first detection steps:
- abolition of the interruption and/or of the reduction of the test current during a defined time interval, with the first switch (S3) being continually open,
- detection of the at least one first variable derived from the test current and/or test voltage by means of the measuring device (M1, M2) during the abolition of the interruption and/or reduction of the test current,
- detection of a separation and/or restoration of the connection between the control apparatus (1) and the load (4) by analyzing the recorded first variable.

4. Control apparatus according to claim 1 or 2, **characterized in that** the control apparatus is set up to carry out the following second detection steps:
- driving of the means (Z1, Z2, S1, S2) for applying the test signal to the load (4) by means of the control circuit (8) with the first switch (S3) open,
- recording of the at least one first variable derived from the test current and/or test voltage by means of the measuring device (M1, M2),
- detection of a separation and/or of a restoration of the connection between the control apparatus (1) and the load (4) by analyzing the recorded first variable.

5. Control apparatus according to any one claims 1 to 4, **characterized in that** the test current is restricted during the first and/or second detection steps in such a manner that an operation of the load (4) as intended remains undone.

6. Control apparatus (1) according to any one of claims 1 to 5, **characterized in that** the control apparatus (1) is furthermore set up for controlling a current flowing from the voltage source (2) to the load (4) by means of the control circuit (8) after detection of the load type for operating the load by driving the first switch (S3) in accordance with a control method allocated to the load type.

7. Control apparatus (1) according to any one of claims 1 to 6, furthermore **characterized by** a communication unit (5) connected with the control circuit (8), wherein the communication unit (5) is configured to receive remote control data for remote control of the control apparatus (1) and/or to send status and/or diagnostic data of the control apparatus (1).

8. Control apparatus (1) according to any one of claims 1 to 7, furthermore **characterized by** a zero voltage detector (10) for detection of zero voltage crossings of the voltage source (2) connected with the control apparatus (1), wherein the moment of the beginning of recording the at least one variable derived from the test current and/or test voltage by the measuring device (M1, M2) relatively to the moment of a detected zero voltage crossing is predetermined.

9. Control apparatus (1) according to any one of claims 1 to 8, **characterized in that** the control apparatus (1) is furthermore set up to carry out the closing of the first switch (S3) within a preset distance of time from the moment of a detected zero voltage crossing.

10. Method for detection of a type of load (4), more particularly by using a control apparatus according to any one of claims 1 to 9, wherein the load (4) can be connected with a voltage source (2) via a first switch (S3) which controls a current flowing to the load (4) to operate the load (4), comprising the following first detection steps:
- applying a test signal to the load (4) with the first switch (S3) open, wherein applying the test signal results in a test current flowing through the load (4) and in a test voltage dropped across the load (4),
- recording at least one first variable derived from the test current and/or test voltage,
**characterized in that** the method comprises the following further detection steps:
- applying an operating current to the load (4) by closing the first switch (S3),
- recording at least one second variable derived from the operating current and/or from an operating voltage dropped across the load (4),
- detection of the load type by analyzing the temporal course of the first and second variables.

11. Method according to claim 10, **characterized in that** the test current is interrupted or reduced after executing the first detection steps.

12. Method according to claim 10 or 11, **characterized by** the following second detection steps:
- applying the test signal to the load (4) with the first switch (S3) open,
- recording the at least one first variable derived from the test current and/or test voltage,
- detection of a separation or of a restoration of a connection to the load (4) by analyzing the recorded first variable.

13. Method according to any one of claims 10 to 12, **characterized in that** the test current is limited during the first and/or second detection steps in such a manner that an operation of the load (4) as intended remains undone.

14. Computer program product comprising instructions executable by a processor to carry out the detection steps of the method according to any one of claims 10 to 13.

## Revendications

1. Dispositif de commande (1) pour la commande d'une charge (4), le dispositif de commande (1) pouvant être branché entre une source de tension (2) et la charge (4), avec un circuit de commande (8), un premier interrupteur (S3) commandé par le circuit de commande (8), qui commande un courant s'écoulant de la source de tension (2) vers la charge (4), et un détecteur de démarrage de type de charge (6), le détecteur de type de charge (6) comprenant des moyens (Z1, Z2, S1, S2) pour l'alimentation de la charge (4) avec un signal de test et au moins un dispositif de mesure (M1, M2), le dispositif de commande (1) étant conçu, pour la détection du type de charge (4), de façon à effectuer les étapes de détection suivantes :
- commande des moyens (Z1, Z2, S1, S2) pour l'alimentation de la charge (4) avec le signal de test par le circuit de commande (8) lorsque le premier interrupteur (S3) est ouvert, l'alimentation avec le signal de test faisant s'écouler un courant de test à travers la charge (4) et faisant chuter une tension de test au niveau de la charge (4),
- mesure d'une première grandeur, déduite à partir du courant de test et/ou de la tension de test, par le dispositif de mesure (M1, M2),
**caractérisé en ce que**
le dispositif de commande (1) est conçu pour effectuer les étapes de détection supplémentaires suivantes :
- alimentation de la charge (4) avec un courant de service par fermeture du premier interrupteur (S3),
- mesure d'au moins une deuxième grandeur, déduite du courant de service et/ou de la tension de service chutant au niveau de la charge, par l'au moins un dispositif de mesure (M1, M2),
- détection du type de charge par analyse du tracé en fonction du temps de la première et de la deuxième grandeur.

2. Dispositif de commande selon la revendication 1, **caractérisé en ce que**, après la réalisation des premières étapes de détection, le courant de test est interrompu ou réduit.

3. Dispositif de commande selon la revendication 2, **caractérisé en ce que** le dispositif de commande est conçu pour effectuer, après les premières étapes de détection, les deuxièmes étapes de détection suivantes :
- annulation de l'interruption ou de la réduction du courant de test pendant un intervalle de temps prédéterminé alors que le premier interrupteur (S3) est toujours ouvert,
- mesure de l'au moins une première grandeur, déduite à partir du courant de test et/ou de la tension de test, par le dispositif de mesure (M1, M2) pendant l'annulation de l'interruption ou de la réduction du courant de test,
- détection d'une séparation et/ou d'un établissement de la liaison entre le dispositif de commande (1) et la charge (4) par analyse de la première grandeur mesurée.

4. Dispositif de commande selon la revendication 1 ou 2, **caractérisé en ce que** le dispositif de commande est conçu pour effectuer les deuxièmes étapes de détection suivantes :
- commande des moyens (Z1, Z2, S1, S2) pour l'alimentation de la charge (4) avec le signal de test par le circuit de commande (8) lorsque le premier interrupteur (S3) est ouvert,
- mesure de l'au moins une première grandeur, déduite à partir du courant de test et/ou de la tension de commande, par le dispositif de mesure (M1, M2),
- détection d'une séparation et/ou d'un établissement de la liaison entre le dispositif de commande (1) et la charge (4) par analyse de la première grandeur.

5. Dispositif de commande selon l'une des revendications 1 à 4, **caractérisé en ce que** le courant de test est limité pendant les premières et/ou les deuxièmes étapes de détection de façon à ce qu'un fonctionnement conforme à l'usage prévu de la charge (4) soit inhibé.

6. Dispositif de commande selon l'une des revendications 1 à 5, **caractérisé en ce que** le dispositif de commande (1) est en outre conçu pour commander, par l'intermédiaire du circuit de commande (8), après la détection du type de charge, un courant qui s'écoule de la source de tension (2) vers la charge (4), pour le fonctionnement de la charge par commande du premier interrupteur (S3) selon une méthode de commande correspondant au type de charge.

7. Dispositif de commande selon l'une des revendications 1 à 6, **caractérisé en outre par** une unité de communication (5) reliée au circuit de commande (8), l'unité de communication (5) étant conçue pour la réception de données de commande à distance pour la commande à distance du dispositif de commande (1) et/ou pour l'émission de données d'état et/ou de diagnostic du dispositif de commande (1).

8. Dispositif de commande selon l'une des revendications 1 à 7, **caractérisé en outre par** un détecteur de tension nulle (10) pour la détection de passages de la tension à zéro de la source de tension (2) reliée au dispositif de commande (1), le moment du début de la mesure de l'au moins une première grandeur, déduite à partir du courant de test et/ou de la tension de test, par le dispositif de mesure (M1, M2), est prédéterminé par rapport au moment d'un passage de la tension à zéro détecté.

9. Dispositif de commande selon l'une des revendications 1 à 8, **caractérisé en ce que** le dispositif de commande (1) est en outre conçu pour effectuer la fermeture du premier interrupteur (S3) à un intervalle temporel prédéterminé par rapport au moment d'un passage de la tension à zéro détecté.

10. Procédé pour la détection du type d'une charge (4), plus particulièrement au moyen d'un dispositif de commande selon l'une des revendications 1 à 9, la charge (4) pouvant être reliée, par l'intermédiaire d'un premier interrupteur (S3), qui commande un courant s'écoulant en direction de la charge (4), pour le fonctionnement de la charge (4), avec une source de tension (2), avec les premières étapes de détection suivantes :
- alimentation de la charge (4) avec un signal de test lorsque le premier interrupteur (S3) est ouvert, l'alimentation avec le signal de test faisant s'écouler un courant de test à travers la charge (4) et faisant chuter une tension de test au niveau de la charge (4),
- mesure d'au moins une première grandeur, déduite à partir du courant de test et/ou de la tension de test,
**caractérisé en ce que**
le procédé comprend les étapes de détection supplémentaires suivantes :
- alimentation de la charge (4) avec un courant de service par fermeture du premier interrupteur (S3),
- mesure d'au moins une deuxième grandeur, déduite à partir du courant de service et/ou de la tension de service chutant au niveau de la charge,
- détection du type de charge par analyse du tracé en fonction du temps de la première et de la deuxième grandeur.

11. Procédé selon la revendication 10, **caractérisé en ce que** le courant de test est interrompu ou réduit après la réalisation des premières étapes de détection.

12. Procédé selon la revendication 10 ou 11, **caractérisé par** les deuxièmes étapes de détection suivantes :
- alimentation de la charge (4) avec le signal de test lorsque le premier interrupteur (S3) est ouvert,
- mesure de l'au moins une première grandeur déduite à partir du courant de test et/ou de la tension de test,
- détection d'une séparation ou de l'établissement d'une liaison avec la charge (4) par analyse de la première grandeur mesurée.

13. Procédé selon l'une des revendications 10 à 12, **caractérisé en ce que** le courant de test est limité pendant les premières et/ou les deuxièmes étapes de détection de façon à ce qu'un fonctionnement conforme à l'usage de la charge soit inhibé.

14. Produit de programme informatique avec des instructions, exécutables par un microprocesseur, pour la réalisation des étapes de détection du procédé selon l'une des revendications 10 à 13.
